# EUROPÄISCHE PATENTSCHRIFT

(11) **EP 3 963 634 B1**
(45) Veröffentlichungstag und Bekanntmachung des Hinweises auf die Patenterteilung: **05.04.2023**
(21) Anmeldenummer: 20750610.6
(22) Anmeldetag: 23.07.2020
(51) Int. Cl.: H01L 27/146

(54) **SENSOREINHEIT**
SENSOR UNIT
UNITÉ DE DÉTECTION

(30) Priorität: 31.07.2019 DE 102019120668
(43) Veröffentlichungstag der Anmeldung: 09.03.2022
(73) Patentinhaber: Leica Camera AG, 35578 Wetzlar (DE)
(72) Erfinder: HOPP, Benjamin, 35390 Gießen (DE); PFEIFFER, Mike, 35578 Wetzlar (DE)
(74) Vertreter: Manitz Finsterwald Patent- und Rechtsanwaltspartnerschaft mbB
(86) Internationale Anmeldenummer: PCT/EP2020/070798
(87) Internationale Veröffentlichungsnummer: WO 2021/018726

(56) Entgegenhaltungen:
- WO-A1-2014/163040
- US-A1- 2014 091 419
- US-A1- 2014 139 912

## Beschreibung

Die vorliegende Erfindung betrifft eine Sensoreinheit für ein Bildaufnahmegerät und ein Bildaufnahmegerät mit einer derartigen Sensoreinheit.

Die Erfindung betrifft insbesondere optoelektronische Bildaufnahmegeräte, etwa Foto- oder Videokameras, mit einem optoelektronischen Halbleitersensor. Derartige Halbleitersensoren detektieren elektromagnetische Strahlung üblicherweise in einem Spektralbereich, der größer ist als das sichtbare Spektrum. Dies hat zur Folge, dass elektromagnetische Strahlung mit Wellenlängen nahe der Ränder des sichtbaren Spektrums diverse Abbildungsfehler hervorrufen kann.

So sind typische Halbleitersensoren gegenüber infrarotem Licht besonders empfindlich, was zu einer fehlerhaften roten Farbwiedergabe des Halbleitersensors führen kann. Beispielsweise können große Lichthöfe um Lichtquellen entstehen oder synthetische Stoffe mit hoher Reflexion im Infrarotbereich können farblich falsch wiedergegeben werden.

Zudem sind Linsenfehler typischer Objektive im Randbereich des sichtbaren Spektrums nicht mehr vollständig korrigiert. Insbesondere der steilere Brechkraftverlauf typischer Linsenmaterialien nahe dem ultravioletten Spektralbereich lässt den Farblängsfehler derartiger Objektive ansteigen und führt am Rand des sichtbaren Spektralbereichs zu unscharfen Farbsäumen.

Darüber hinaus kann es vorkommen, dass Halbleitersensoren mit Farbfiltern das Licht in den Randbereichen des sichtbaren Spektrums fehlerhaft interpretieren.

Beispielsweise kann das rote Farbpigment eines derartigen Farbfilters eine Nebentransmission nahe dem ultravioletten Spektralbereich aufweisen, sodass bei gleichzeitiger Transmission des blauen und roten Farbpigments magentafarbene Farbfehler auftreten können. Eine Kombination einer unscharfen Abbildung nahe dem ultravioletten Spektralbereich mit einer magentafarbenen Interpretation der unscharf abgebildeten Strahlung durch den Halbleitersensor führt dann zu charakteristischen violetten Farbsäumen (*purple fringing*).

Zur Vermeidung derartiger Abbildungsfehler wird daher bei optoelektronischen Bildaufnahmegeräten die einfallende elektromagnetische Strahlung üblicherweise auf einen zweckmäßigen Spektralbereich begrenzt. Hierzu können unter anderem Deckglasaufbauten verwendet werden, welche den optoelektronischen Halbleitersensor auf der Objektseite abdecken und ein oder mehrere Filterelemente aufweisen. Neben einer Begrenzung des Spektralbereichs des einfallenden Lichts (spektrale Filterung), dienen derartige Deckglasaufbauten auch dazu, den Halbleitersensor vor Verunreinigungen und Umwelteinflüssen zu schützen und eine Reinigung der Außenseite des Sensoraufbaus zu ermöglichen, ohne den Halbleitersensor selbst zu beschädigen.

Deckglasaufbauten optoelektronischer Halbleitersensoren umfassen üblicherweise ein Infrarot-Absorptionsglas (IR-Absorptionsglas), welches die auf den Deckglasaufbau einfallende elektromagnetische Strahlung im roten Spektralbereich dadurch begrenzt, dass Strahlung des betreffenden Spektralbereichs im Absorptionsglas absorbiert wird. Reine IR-Absorptionsgläser begrenzen jedoch das Spektrum der einfallenden elektromagnetischen Strahlung nur ungenügend. Dies gilt insbesondere in Spektralbereichen nahe dem ultravioletten Bereich.

Daher wird das Spektrum der einfallenden Strahlung üblicherweise mittels zusätzlicher UV-Sperrschichten begrenzt, die in Dünnschichttechnik auf ein Trägerglas, beispielsweise das IR-Absorptionsglas des Deckglasaufbaus, aufgebracht werden und typischerweise als Interferenzschichten ausgebildet sind. Derartige Sperrschichten transmittieren die auf den Sensoraufbau einfallende elektromagnetische Strahlung in einem als Durchlassbereich bezeichneten Spektralbereich und reflektieren die einfallende Strahlung in einem als Sperrbereich bezeichneten Spektralbereich. US 2014/139912 A1 offenbart eine Sensoreinheit gemäß dem Stand der Technik.

Ein Nachteil von reflektierenden Sperrschichten ist, dass deren Reflexionsvermögen üblicherweise stark mit dem Winkel, unter dem die elektromagnetische Strahlung auf die Sperrschicht einfällt, variiert und flach auf die Sperrschicht einfallende Strahlung oftmals nur ungenügend reflektiert wird und daher auf den Sensor treffen kann. Unter flachen Einfallswinkeln einfallende Strahlung tritt insbesondere bei kompakten Bildaufnahmegeräten, beispielsweise bei spiegellosen Systemkameras, auf.

Es ist Aufgabe der Erfindung, eine Sensoreinheit für ein Bildaufnahmegerät und ein Bildaufnahmegerät derart anzugeben, dass Abbildungsfehler, insbesondere im kurzwelligen Spektralbereich auftretende Abbildungsfehler, vermieden werden. Diese Aufgabe wird durch eine Sensoreinheit und ein Bildaufnahmegerät gemäß den unabhängigen Ansprüchen gelöst. Weiterbildungen sind jeweils in den abhängigen Ansprüchen angegeben.

Eine Sensoreinheit für ein Bildaufnahmegerät umfasst einen optoelektronischen Bildsensor und eine vor dem optoelektronischen Bildsensor angeordnete Abdeckeinheit, wobei die Abdeckeinheit ein erstes Absorptionsglas und ein zweites Absorptionsglas umfasst und wobei das erste Absorptionsglas als ein UV-Absorptionsglas und das zweite Absorptionsglas als ein IR-Absorptionsglas ausgebildet ist.

Anders als bei bisher bekannten Sensoreinheiten wird also bei der beschriebenen Sensoreinheit zur Filterung der einfallenden elektromagnetischen Strahlung im ultravioletten Spektralbereich ein UV-Absorptionsglas eingesetzt, welches ultraviolette Strahlung nicht reflektiert, sondern absorbiert. Gegenüber den herkömmlicherweise eingesetzten UV-Sperrschichten hat dies den Vorteil, dass die von dem Absorptionsglas zurückgehaltene Strahlung aus dem optischen System des Bildaufnahmegeräts entfernt wird und nicht mehr, beispielsweise aufgrund von Mehrfachreflexionen und dabei auftretenden flachen Einfallswinkeln auf die Sperrschicht, durch die Abdeckeinheit hindurchtreten kann. Dies verringert farbige Linsenreflektionen in den von der Sensoreinheit aufgenommenen Bildern, welche oftmals als störend und unnatürlich empfunden werden.

Farbige Linsenreflektionen treten bei mit Sperrschichten ausgestatteten Abdeckeinheiten unter anderem dann auf, wenn der reflektierte blaue Anteil der auf die Sensoreinheit einfallenden elektromagnetischen Strahlung an einem vor der Sensoreinheit angeordneten Objektiv erneut in Richtung der Sensoreinheit zurückreflektiert wird. Je größer dabei der gegenüber der Normalen der Abdeckeinheit gemessene Einfallswinkel der vom Objektiv zurückreflektierten Strahlung ist, desto größer ist auch der Anteil der Strahlung, der aufgrund der winkelabhängigen Filtercharakteristik der Sperrschicht durch diese durchgelassen wird. Dies ist insbesondere bei Bildaufnahmegeräten mit geringen Schnittweiten, wie beispielsweise spiegellosen Systemkameras, ein Problem, da aufgrund der kurzen Distanz zwischen Bildsensor und hinterstem optischen Element eines vor dem Bildsensor angeordneten Objektivs auch noch unter großen Winkeln am Objektiv reflektierte Strahlung erneut auf die Sensoreinheit treffen kann.

Das erste Absorptionsglas und/oder das zweite Absorptionsglas können jeweils einen oder mehrere Farbstoffe enthalten, welche durch das Absorptionsglas hindurchtretende elektromagnetische Strahlung wellenlängenselektiv absorbieren.

Das als UV-Absorptionsglas ausgebildete erste Absorptionsglas bildet im sichtbaren Spektralbereich (380nm bis 740nm) einen Langpassfilter. Das erste Absorptionsglas kann derart ausgebildet sein, dass eine Grenzwellenlänge des ersten Absorptionsglases, bei welcher eine externe Transmission des ersten Absorptionsglases 50% beträgt (UV50%), im blauen Spektralbereich liegt. Des Weiteren kann das erste Absorptionsglas derart ausgebildet sein, dass dessen Transmission bei allen Wellenlängen des sichtbaren Spektralbereichs, die größer sind als die UV50% Grenzwellenlänge, über 50% und bei allen Wellenlängen des sichtbaren Spektralbereichs, die kleiner sind als die UV50% Grenzwellenlänge, unter 50% liegt.

Die UV50% Grenzwellenlänge kann beispielsweise zwischen 380nm und 450nm, etwa zwischen 405nm und 430nm, bevorzugt zwischen 415nm und 420nm, etwa bei 417nm liegen. Das erste Absorptionsglas kann beispielsweise ein Glas sein, welches unter der Bezeichnung UV CLEAR 8010HT von der Firma Corning SAS, Frankreich, vertrieben wird. Das erste Absorptionsglas kann auch ein Glas sein, welches unter der Bezeichnung UV418 von der Firma Corning SAS, Frankreich, vertrieben wird, oder ein Glas, welches von der Firma Schott AG, Deutschland, unter der Bezeichnung GG435 vertrieben wird. Das erste Absorptionsglas kann in einer senkrecht zu einer eine Erfassungsfläche des Bildsensors bildenden Oberfläche des Bildsensors orientierten Dickenrichtung eine Dicke zwischen 0,1 und 0,7mm, beispielsweise zwischen 0,2mm und 0,6mm, etwa von 0,3mm oder 0,5mm aufweisen.

Das als IR-Absorptionsglas ausgebildete zweite Absorptionsglas bildet im sichtbaren Spektralbereich einen Kurzpassfilter. Das zweite Absorptionsglas kann derart ausgebildet sein, dass eine Grenzwellenlänge des zweiten Absorptionsglases, bei welcher eine externe Transmission des zweiten Absorptionsglases 50% beträgt (IR50%), im roten Spektralbereich liegt. Desweiteren kann das zweite Absorptionsglas derart ausgebildet sein, dass dessen Transmission bei allen Wellenlängen des sichtbaren Spektralbereichs, die kleiner sind als die IR50% Grenzwellenlänge, über 50% und bei allen Wellenlängen des sichtbaren Spektralbereichs, die größer sind als die IR50% Grenzwellenlänge, unter 50% liegt. Die IR50% Grenzwellenlänge kann beispielsweise zwischen 520nm und 700nm, etwa zwischen 580nm und 610nm, bevorzugt zwischen 585nm und 600nm, etwa bei 587nm oder 592nm liegen. Allgemein kann das zweite Absorptionsglas in der Dickenrichtung eine Dicke zwischen 0,4mm und 1,0mm, insbesondere zwischen 0,5mm und 0,8mm aufweisen.

Das zweite Absorptionsglas kann beispielsweise ein Glas sein, welches unter der Bezeichnung IR584-18α von der Firma MATSUNAMI GLASS IND., LTD., Japan, vertrieben wird. Insbesondere in diesem Fall kann das zweite Absorptionsglas in der Dickenrichtung eine Dicke zwischen 0,4 und 0,8mm, beispielsweise zwischen 0,5mm und 0,7mm, etwa von 0,60mm aufweisen. Es kann auch ein Glas sein, welches unter der Bezeichnung IR584-16α von der Firma MATSUNAMI GLASS IND., LTD., Japan, vertrieben wird. Insbesondere in diesem Fall kann das zweite Absorptionsglas in der Dickenrichtung eine Dicke zwischen 0,6 und 1,0mm, beispielsweise zwischen 0,7mm und 0,8mm, etwa von 0,76mm aufweisen. Außerdem kann das zweite Absorptionsglas ein Glas sein, welches unter der Bezeichnung CXA700 von der Firma HOYA CANDEO OPTRONICS, Japan, vertrieben wird. Insbesondere in diesem Fall kann das zweite Absorptionsglas in der Dickenrichtung eine Dicke zwischen 0,4mm und 0,7mm, beispielsweise zwischen 0,5mm und 0,6mm, etwa von 0,57mm aufweisen.

Oberflächen der Abdeckeinheit, welche einen Glas-Luft-Übergang bilden, können jeweils mit einer Antireflexbeschichtung beschichtet sein. Dies gilt insbesondere für eine dem Bildsensor abgewandte objektseitige Vorderfläche und eine dem Bildsensor zugewandte bildseitige Rückfläche der Abdeckeinheit.

Die gesamte Abdeckeinheit kann, inklusive möglicherweise vorhandener Beschichtungen, einen Sperrbereich mit einer UV50% Grenzwellenlänge aufweisen, welche in einem Bereich von höchstens +/- 30nm, insbesondere höchstens +/- 20nm, bevorzugt höchstens +/-10nm, um eine Wellenlänge von 425 nm liegt. Außerdem kann die gesamte Abdeckeinheit eine IR50% Grenzwellenlänge aufweisen, welche in einem Bereich von (620 +/- 50) nm, insbesondere in einem Bereich von (600 +/- 25) nm, bevorzugt in einem Bereich von (595 +/- 10) nm liegt.

Das erste Absorptionsglas und das zweite Absorptionsglas können plattenförmig ausgebildet und parallel zu der Erfassungsfläche des Halbleitersensors ausgerichtet sein. Das erste Absorptionsglas und das zweite Absorptionsglas können entlang einer senkrecht zu der Erfassungsfläche des Halbleitersensors orientierten optischen Achse hintereinander angeordnet sein.

Das erste Absorptionsglas und das zweite Absorptionsglas können aneinander anliegen und direkt miteinander verbunden, beispielsweise verklebt, verkittet oder angesprengt, sein. Das erste Absorptionsglas und das zweite Absorptionsglas können jedoch auch voneinander beabstandet angeordnet und beispielsweise über einen Abstandshalter miteinander verbunden sein. In diesem Fall kann sich zwischen dem ersten Absorptionsglas und dem zweiten Absorptionsglas beispielsweise ein Freiraum befinden.

Die Abdeckeinheit kann neben dem ersten Absorptionsglas und dem zweiten Absorptionsglas noch weitere Absorptionsgläser, Sperrschichten, insbesondere eine oder mehrere IR-Sperrschichten und/oder eine oder mehrere UV-Sperrschichten, Antireflexbeschichtungen oder weitere optische Elemente umfassen. Die Abdeckeinheit kann mit dem optoelektronischen Bildsensor verbunden sein, etwa über ein Gehäuse des Bildsensors. Beispielsweise kann die Abdeckeinheit mit dem optoelektronischen Bildsensor, insbesondere mit dessen Gehäuse, verklebt oder mittels eines Klemmelements verbunden sein. Die Sensoreinheit mit der Abdeckeinheit und dem optoelektronischen Bildsensor kann in einem Gehäuse eines Bildaufnahmegeräts angeordnet und mit diesem verbunden, beispielsweise verschraubt, sein.

Der optoelektronische Bildsensor kann als ein Halbleitersensor, beispielsweise als ein CMOS- oder CCD-Sensor, ausgebildet sein. Die Erfassungsfläche des Halbleitersensors kann eine Diagonale aufweisen, die mindestens so groß ist wie die Schnittweite eines die Sensoreinheit umfassenden Bildaufnahmegeräts, beispielsweise einmal oder 1 ,2-mal oder 1 ,5-mal so groß.

Bei einer Weiterbildung der Sensoreinheit ist das erste Absorptionsglas an einer dem Bildsensor abgewandten Vorderseite des zweiten Absorptionsglases angeordnet. Dadurch kann eine der Vorderseite abgewandte Rückseite des zweiten Absorptionsglases direkt über einer den optoelektronischen Bildsensor enthaltenden Kavität der Sensoreinheit angeordnet werden, so dass die Kavität nur durch das zweite Absorptionsglas, nicht jedoch durch das erste Absorptionsglas abgedeckt wird und von Klebstoffen ausgehende Ausgasungen, beispielsweise Ausgasungen, die von zwischen dem ersten und dem zweiten Absorptionsglas angeordneten Klebstoffen ausgehen, die Funktionsfähigkeit des optoelektronischen Bildsensors nicht beeinträchtigen können.

Bei einer alternativen Ausführungsform der Sensoreinheit ist das erste Absorptionsglas an einer dem Bildsensor zugewandten Rückseite des zweiten Absorptionsglases angeordnet. Dabei kann das zweite Absorptionsglas insbesondere innerhalb einer den optoelektronischen Bildsensor umfassenden Kavität angeordnet sein, so dass die Sensoreinheit eine besonders geringe Bauhöhe entlang der optischen Achse aufweisen kann.

Bei einer Weiterbildung der Sensoreinheit überdeckt die Abdeckeinheit eine den Bildsensor enthaltende Kavität der Sensoreinheit. Die Kavität ist dann vollständig unter der Abdeckeinheit angeordnet. Die Abdeckeinheit kann die Kavität dabei in longitudinaler Richtung nach vorne direkt abschließen. Die Kavität kann jedoch auch durch ein zusätzliches, die Kavität ebenfalls überdeckendes und mit der Abdeckeinheit verbundenes Element, etwa ein Klarglas, verschlossen sein und die die Kavität überdeckende Abdeckeinheit kann vor dem zusätzlichen Element angeordnet sein. Das zusätzliche Element kann insbesondere plattenförmig ausgebildet sein. Indem eine die Kavität überdeckende Abdeckeinheit zur Filterung der einfallenden elektromagnetischen Strahlung verwendet wird, kann die Sensoreinheit entlang der optischen Achse besonders kompakt ausgeführt werden.

Bei einer Weiterbildung der Sensoreinheit ist das erste Absorptionsglas und/oder das zweite Absorptionsglas als plattenförmiges Element ausgebildet, welches in einer senkrecht zu einer Oberfläche des Bildsensors ausgerichteten Dickenrichtung eine geringere Ausdehnung aufweist als in parallel zu der Oberfläche des Bildsensors ausgerichteten transversalen Richtungen. Die Dickenrichtung kann dabei entlang der optischen Achse ausgerichtet sein. Plattenförmige Absorptionsgläser sind besonders einfach herzustellen und haben keinen Einfluss auf das Abbildungsverhalten eines die Sensoreinheit umfassenden optischen Systems des Bildaufnahmegeräts.

Bei einer Weiterbildung der Sensoreinheit sind das erste Absorptionsglas und das zweite Absorptionsglas aneinander anliegend angeordnet und vorzugsweise flächig miteinander verbunden, beispielsweise verklebt, verkittet oder angesprengt. Gegenüber einer beabstandeten Anordnung des ersten und zweiten Absorptionsglases befinden sich bei aneinander anliegenden Absorptionsgläsern keine Glas-Luft-Übergänge zwischen den Absorptionsgläsern, so dass Reflexionen innerhalb der Abdeckeinheit reduziert werden können. Zwischen den aneinander anliegenden Absorptionsgläsern kann zur Verbindung derselben eine Verbindungsschicht angeordnet sein, welche beispielsweise einen Klebstoff oder einen Kitt enthalten kann.

Bei einer Weiterbildung der Sensoreinheit unterscheidet sich ein erster Brechungsindex des ersten Absorptionsglases um höchstens 10%, beispielsweise um höchstens 3% oder höchstens 1%, von einem zweiten Brechungsindex des zweiten Absorptionsglases. Dadurch können insbesondere bei aneinander anliegenden Absorptionsgläsern Reflexionen zwischen dem ersten Absorptionsglas und dem zweiten Absorptionsglas reduziert werden.

Bei einer Weiterbildung der Sensoreinheit unterscheidet sich ein dritter Brechungsindex einer zwischen dem ersten Absorptionsglas und dem zweiten Absorptionsglas angeordneten Verbindungsschicht von dem ersten Brechungsindex und/oder dem zweiten Brechungsindex um höchstens 10%, beispielsweise um höchstens 3% oder höchstens 1%. Insbesondere kann der dritte Brechungsindex zwischen dem ersten und dem zweiten Brechungsindex liegen. Ein derartig gewählter dritter Brechungsindex führt zu besonders geringen Reflexionen an den Grenzflächen zwischen dem ersten und dem zweiten Absorptionsglas.

Bei einer Weiterbildung der Sensoreinheit weist ein Kleineres der beiden Absorptionsgläser in einer parallel zu einer Oberfläche des Bildsensors orientierten lateralen Richtung eine geringere Ausdehnung auf als ein Größeres der beiden Absorptionsgläser. Dadurch wird das größere Absorptionsglas auf dessen dem kleineren Absorptionsglas zugewandter Seite nicht vollständig durch das kleinere Absorptionsglas überdeckt, so dass das größere Absorptionsglas einen freiliegenden Rand aufweist. Der freiliegende Rand kann um das größere Absorptionsglas umlaufend ausgebildet sein oder in der lateralen Richtung lediglich auf einer Seite oder in der lateralen Richtung auf zwei einander gegenüberliegenden Seiten des größeren Absorptionsglases vorhanden sein. Bei dem kleineren Absorptionsglas kann es sich um das erste Absorptionsglas und bei dem größeren Absorptionsglas um das zweite Absorptionsglas handeln, oder umgekehrt.

Bei einer Weiterbildung der Sensoreinheit liegt die Abdeckeinheit auf einer Auflagefläche eines den optoelektronischen Bildsensor umgebenden Rahmens der Sensoreinheit auf, wobei die Auflagefläche in der lateralen Richtung zumindest teilweise nicht durch das kleinere Absorptionsglas überdeckt wird. Indem die Abdeckeinheit auf dem Rahmen der Sensoreinheit aufliegt, kann die Sensoreinheit besonders kompakt ausgeführt werden. In dem freiliegenden Bereich, der nicht durch das kleinere Absorptionsglas überdeckt wird, kann beispielsweise eine Klebeverbindung oder eine Klemmverbindung angeordnet sein, welche die Abdeckeinheit an dem Rahmen der Sensoreinheit befestigt. Der Rahmen kann beispielsweise Teil eines den optoelektronischen Bildsensor umgebenden Gehäuses sein und eine in dem Gehäuse ausgebildete und den Bildsensor enthaltende Kavität umgeben.

Bei einer Weiterbildung der Sensoreinheit wird das kleinere Absorptionsglas durch das erste Absorptionsglas und das größere Absorptionsglas durch das zweite Absorptionsglas gebildet. Zwischen dem kleineren Absorptionsglas und dem Bildsensor ist in einem in der lateralen Richtung nicht durch das erste Absorptionsglas überdeckten Randbereich der Sensoreinheit eine einen UV-lichthärtenden Klebstoff umfassende Klebeverbindung angeordnet. Die Klebeverbindung kann beispielsweise das zweite Absorptionsglas mit dem den optoelektronischen Bildsensor umgebenden Rahmen der Sensoreinheit verbinden. Indem die Klebeverbindung in dem nicht durch das erste Absorptionsglas überdeckten Randbereich der Sensoreinheit angeordnet wird, kann zur Aushärtung der Klebeverbindung verwendetes UV-Licht an dem ersten Absorptionsglas vorbei auf die Klebeverbindung eingestrahlt werden.

Bei einer Weiterbildung umfasst die Sensoreinheit ein Befestigungselement, mit welchem die Abdeckeinheit an dem optoelektronischen Bildsensor befestigt ist.

Dabei ist das Befestigungselement an einer dem kleineren Absorptionsglas zugewandten Befestigungsseite des größeren Absorptionsglases und in der lateralen Richtung neben dem kleineren Absorptionsglas angeordnet. Bei einer derartigen Anordnung weist die Sensoreinheit in eine longitudinale Richtung entlang der optischen Achse eine besonders geringe Ausdehnung auf.

Das Befestigungselement kann insbesondere auf einer dem optoelektronischen Bildsensor abgewandten Vorderseite des größeren Absorptionsglases auf dem größeren Absorptionsglas aufliegen und das kleinere Absorptionsglas kann ebenfalls auf der Vorderseite des größeren Absorptionsglases angeordnet sein. Das Befestigungselement kann ein Klemmelement umfassen, welches an einer lateralen Seite des größeren Absorptionsglases oder um das größere Absorptionsglas umlaufend angeordnet ist.

Bei einer Weiterbildung der Sensoreinheit weist das größere Absorptionsglas auf seiner dem kleineren Absorptionsglas zugewandten Seite eine Schutzbeschichtung auf, welche zumindest einen in der lateralen Richtung nicht durch das kleinere Absorptionsglas überdeckten freiliegenden Bereich des größeren Absorptionsglases bedeckt. Dadurch kann eine Korrosion des größeren Absorptionsglases im freiliegenden Bereich verhindert werden. Die Schutzbeschichtung kann beispielsweise zugleich als eine Antireflexbeschichtung ausgeführt sein.

Bei einer Weiterbildung der Sensoreinheit ist die Schutzbeschichtung vollflächig auf der dem kleineren Absorptionsglas zugewandten Seite des größeren Absorptionsglases angeordnet. Insbesondere kann die Schutzbeschichtung auch zwischen dem kleineren Absorptionsglas und dem größeren Absorptionsglas gebildet sein. Eine derartige Schutzbeschichtung ist besonders einfach herzustellen. Bei alternativen Ausführungsformen kann die Schutzbeschichtung auch lediglich in dem nicht durch das kleinere Absorptionsglas überdeckten freiliegenden Bereich ausgebildet sein. Der freiliegende Bereich kann durch den nicht durch das kleinere Absorptionsglas überdeckten Randbereich des größeren Absorptionsglases gebildet werden.

Bei einer Weiterbildung der Sensoreinheit umfasst die Abdeckeinheit eine IR-Sperrschicht. Mittels einer IR-Sperrschicht kann die auf den optoelektronischen Bildsensor einfallende elektromagnetische Strahlung nahe dem infraroten Wellenlängenbereich zusätzlich begrenzt werden. Dies ermöglicht es, das einfallende elektromagnetische Spektrum auch dann wirkungsvoll zu begrenzen, wenn das zweite Absorptionsglas eine verhältnismäßig flache Filterkante aufweist. Die IR-Sperrschicht kann als eine Interferenzschicht ausgebildet sein. Sie kann eine Filterkante aufweisen, welche zwischen 650nm und 700nm, beispielsweise zwischen 670nm und 680nm liegt. Die IR-Sperrschicht kann bei 700nm eine Transmission von höchstens 10%, beispielsweise höchstens 5%, höchstens 2% oder höchstens 1% aufweisen.

Bei einer Weiterbildung der Sensoreinheit umfasst die Abdeckeinheit ein drittes Absorptionsglas, welches als ein IR-Absorptionsglas ausgebildet ist. Die IR-Sperrschicht ist dabei zwischen dem zweiten und dem dritten Absorptionsglas angeordnet. Dadurch wird von der IR-Sperrschicht reflektierte elektromagnetische Strahlung auf beiden Seiten der IR-Sperrschicht in einem der IR-Absorptionsgläser absorbiert, so dass die reflektierte elektromagnetische Strahlung aus dem Strahlengang eines die Sensoreinheit umfassenden Bildaufnahmegeräts entfernt wird und durch die reflektierte rote Strahlung hervorgerufene Abbildungsfehler vermieden werden. Soweit keine Unterschiede beschrieben werden, kann das dritte Absorptionsglas ausgebildet sein, wie es für das zweite Absorptionsglas beschrieben wird.

Die IR-Sperrschicht kann direkt zwischen den beiden IR-Absorptionsgläsern angeordnet sein. Insbesondere können entlang der optischen Achse eines der beiden IR-Absorptionsgläser, die IR-Sperrschicht, das weitere IR-Absorptionsglas und das UV-Absorptionsglas nacheinander angeordnet sein. Die IR-Sperrschicht kann jedoch auch alternativ zwischen einem der beiden IR-Absorptionsgläser und dem als UV-Absorptionsglas ausgebildeten ersten Absorptionsglas angeordnet sein. Insbesondere können entlang der optischen Achse eines der beiden IR-Absorptionsgläser, das UV-Absorptionsglas, die IR-Sperrschicht, sowie das weitere IR-Absorptionsglas nacheinander angeordnet sein. Bei all diesen Aufbauten können die IR-Absorptionsgläser, die IR-Sperrschicht, sowie das UV-Absorptionsglas direkt aneinander anliegend angeordnet und jeweils miteinander verbunden sein.

Neben der IR-Sperrschicht kann die Abdeckeinheit auch eine UV-Sperrschicht umfassen. Die UV-Sperrschicht kann getrennt von der IR-Sperrschicht oder mit dieser verbunden bzw. in diese integriert ausgeführt sein.

Bei einer Weiterbildung der Sensoreinheit ist das dritte Absorptionsglas auf einer dem ersten Absorptionsglas abgewandten Seite des zweiten Absorptionsglases angeordnet. Dies ermöglicht es, die IR-Sperrschicht zwischen dem zweiten Absorptionsglas und dem dritten Absorptionsglas anzuordnen. Dabei kann die IR-Sperrschicht insbesondere in eine Verbindungsschicht, welche das zweite Absorptionsglas mit dem dritten Absorptionsglas verbindet, integriert sein. Dadurch kann eine Abdeckeinheit realisiert werden, welche im roten Spektralbereich zum einen eine steile Filterkurve und zum anderen unabhängig von der Richtung, aus der die Strahlung auf den Absorptionsglasaufbau einfällt, eine hohe Absorption aufweist.

Es wird ferner ein Bildaufnahmegerät mit der vorgenannten Sensoreinheit angegeben. Dabei beziehen sich alle Vorteile und Weiterbildungen, welche im Zusammenhang mit der Sensoreinheit beschrieben werden, auch auf das Bildaufnahmegerät.

Das Bildaufnahmegerät kann insbesondere als eine spiegellose Systemkamera ausgebildet sein. Das Bildaufnahmegerät kann derart ausgebildet sein, dass die Diagonale des optoelektronischen Bildsensors der Sensoreinheit mindestens so groß ist wie die Schnittweite des Bildaufnahmegeräts, beispielsweise einmal oder 1,2-mal oder 1,5-mal so groß.

Die Erfindung wird nachfolgend anhand von Figuren erläutert. Dabei zeigen in jeweils schematischer Darstellung:
- Fig. 1: ein Bildaufnahmegerät mit einer Sensoreinheit gemäß dem Stand der Technik und einem vor der Sensoreinheit angeordneten optischen Element;
- Fig. 2: eine Abdeckeinheit der Sensoreinheit gemäß einer ersten Ausführungsform;
- Fig. 3: die Abdeckeinheit der Sensoreinheit gemäß einer zweiten Ausführungsform;
- Fig. 4: die Abdeckeinheit der Sensoreinheit gemäß einer dritten Ausführungsform;
- Fig. 5: die Sensoreinheit mit einer vierten Ausführungsform der Abdeckeinheit;
- Fig. 6: die Sensoreinheit mit einer fünften Ausführungsform der Abdeckeinheit;
- Fig. 7: eine Aufsicht auf eine Vorderseite der Abdeckeinheit gemäß der vierten Ausführungsform;
- Fig. 8: die Sensoreinheit mit einer sechsten Ausführungsform der Abdeckeinheit;
- Fig. 9: eine Detailansicht der Sensoreinheit mit der sechsten Ausführungsform der Abdeckeinheit;
- Fig. 10: eine Transmissionskurve der Abdeckeinheit; und
- Fig. 11: eine alternative Transmissionskurve der Abdeckeinheit.

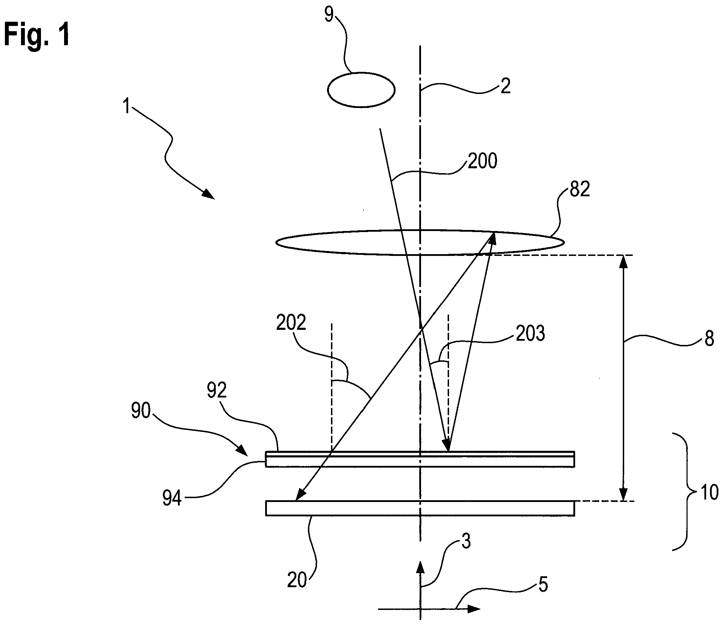

Fig. 1 zeigt eine schematische Darstellung eines Bildaufnahmegeräts 1 mit einer Sensoreinheit 10 gemäß dem Stand der Technik. Die Sensoreinheit 10 ist entlang einer optischen Achse 2 des Bildaufnahmegeräts 1 hinter bzw. bildseitig von einem als Linse ausbildeten optischen Element 82 eines nicht dargestellten Objektivs des Bildaufnahmegeräts 1 angeordnet.

Die Sensoreinheit 10 umfasst einen optoelektronischen Bildsensor 20 und eine entlang der optischen Achse 2 vor dem Bildsensor 20, d. h. objektseitig, angeordnete Abdeckeinheit 90. Die Abdeckeinheit 90 umfasst ihrerseits ein plattenförmiges Absorptionsglas 94 und eine auf der objektseitigen Vorderseite des Absorptionsglases 94 angeordnete Sperrschicht 92. Das Absorptionsglas 94 ist als ein IR-Absorptionsglas und die Sperrschicht 92 als eine UV-Sperrschicht ausgebildet. Das plattenförmige Absorptionsglas 94 weist in einer transversalen Richtung 5 eine größere Ausdehnung aus als in einer entlang der optischen Achse 2 und senkrecht zu der transversalen Richtung 5 orientierten longitudinalen Richtung 3.

Das optische Element 82 bildet ein letztes bzw. hinterstes optisches Element des Objektivs. Der Bildsensor 20 und das optische Element 82 sind in einem Abstand voneinander angeordnet, der einer minimalen Schnittweite 8 des Bildaufnahmegeräts 1 entspricht.

Wie Fig. 1 zu entnehmen ist, wird von einem vor dem Objektiv angeordneten Objekt 9 ausgehende elektromagnetische Strahlung 200 an der Sperrschicht 92 in Richtung des Objektivs zurückreflektiert. Anschließend wird ein Teil der zurückreflektierten Strahlung 200 an dem optischen Element 82 des Objektivs erneut reflektiert und trifft erneut auf die Abdeckeinheit 90. Abhängig von der Geometrie des optischen Elements 82 kann dabei ein zweiter Einfallswinkel 202 nach Reflexion der erneut reflektierten elektromagnetischen Strahlung 200 größer sein als ein erster Einfallswinkel 203, unter dem die elektromagnetische Strahlung 200 zuvor auf die Abdeckeinheit 90 getroffen ist. Da die Reflektivität der Sperrschicht 92 winkelabhängig ist und mit zunehmendem Einfallswinkel 202, 203 abnimmt, tritt die vom optischen Element 82 rückreflektierte und nach Reflexion unter dem grö-ßeren zweiten Einfallswinkel 202 eintreffende elektromagnetische Strahlung 200 durch die Sperrschicht 92 hindurch und trifft schließlich auf den Bildsensor 20. Ein von dem Bildsensor 20 aufgenommenes Bild zeigt dann eine Linsenreflektion, welche aufgrund der farbselektiven Reflexion an der UV-Sperrschicht 92 eine blaue Färbung aufweist. Insbesondere bei einem Bildaufnahmegerät, bei dem die Schnittweite 8 im Vergleich zur Ausdehnung des Bildsensors 20 in transversaler Richtung 5 verhältnismäßig klein ist, können nach Reflexion an dem Objektiv gro-ße zweite Einfallswinkel 202 von bis zu 40° auftreten.

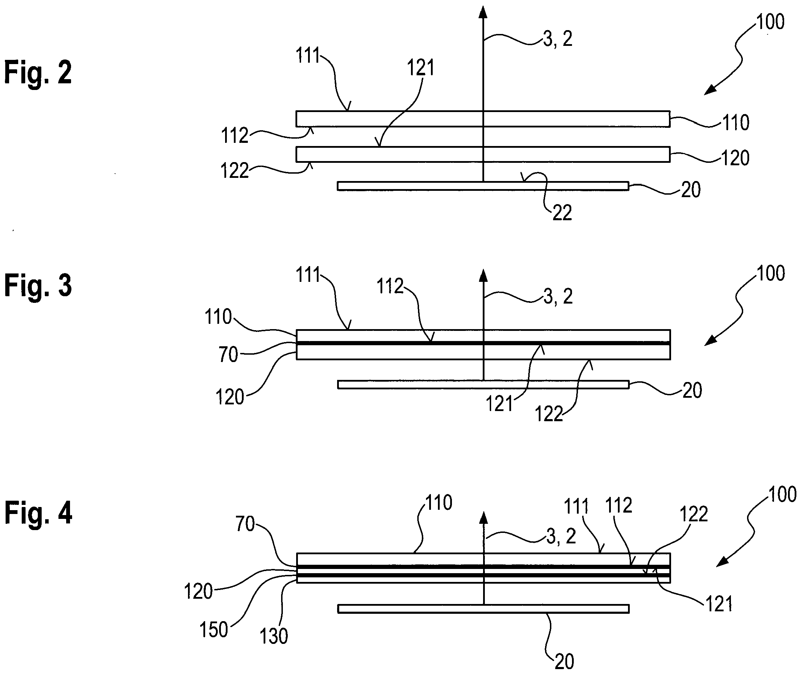

Zur Vermeidung der beschriebenen farbigen Linsenreflektionen wird bei den erfindungsgemäßen Sensoreinheiten 10 eine Abdeckeinheit verwendet, welche ein UV-Absorptionsglas umfasst, das einfallende elektromagnetische Strahlung im violetten und nah-ultravioletten Spektralbereich vornehmlich absorbiert und nicht reflektiert. Fig. 2 zeigt eine erste Ausführungsform einer derartigen Abdeckeinheit 100.

Die Abdeckeinheit 100 weist ein als UV-Absorptionsglas ausgebildetes erstes Absorptionsglas 110 und ein als IR-Absorptionsglas ausgebildetes zweites Absorptionsglas 120 auf. Das erste und das zweite Absorptionsglas 110, 120 sind voneinander beabstandet vor einer als Erfassungsfläche zur Detektion einfallender elektromagnetischer Strahlung dienenden Oberfläche 22 des Bildsensors 20 angeordnet. Ausgehend von dem Bildsensor 20 ist dabei in longitudinaler Richtung 3 entlang der optischen Achse 2 zunächst das zweite Absorptionsglas 120 und vor dem zweiten Absorptionsglas 120 das erste Absorptionsglas 110 angeordnet. Dabei ist eine Vorderseite 111 des ersten Absorptionsglases 110 der einfallenden elektromagnetischen Strahlung und eine der Vorderseite 111 gegenüberliegende Rückseite 112 des ersten Absorptionsglases 110 dem zweiten Absorptionsglas 120 zugewandt angeordnet. Eine Vorderseite 121 des zweiten Absorptionsglases 120 ist dem ersten Absorptionsglas 110 und eine der Vorderseite 121 gegenüberliegende Rückseite 122 des zweiten Absorptionsglases 120 ist dem Bildsensor 20 zugewandt angeordnet.

Fig. 3 zeigt eine zweite Ausführungsform der Abdeckeinheit 100. Soweit keine Unterschiede beschrieben werden, ist die zweite Ausführungsform der Abdeckeinheit 100 ausgebildet, wie es für die erste Ausführungsform der Abdeckeinheit 100 beschrieben wird. Bei der zweiten Ausführungsform sind das erste Absorptionsglas 110 und das zweite Absorptionsglas 120 nicht voneinander beabstandet, sondern aneinander anliegend angeordnet. Zwischen dem ersten Absorptionsglas 110 und dem zweiten Absorptionsglas 120 befindet sich eine als Klebeschicht ausgebildete Verbindungsschicht 70, welche das erste und zweite Absorptionsglas 110, 120 vollflächig miteinander verbindet.

Bei der Fig. 2 dargestellten ersten Ausführungsform und bei der in Fig. 3 dargestellten zweiten Ausführungsform kann die Abdeckeinheit 100 jeweils eine IR-Sperrschicht umfassen, welche beispielsweise auf der Vorderseite 111 des ersten Absorptionsglases 110 angeordnet sein kann. Zusätzlich oder alternativ kann die Abdeckeinheit 100 jeweils eine UV-Sperrschicht umfassen, welche beispielsweise ebenfalls auf der Vorderseite 111 des ersten Absorptionsglases 110 angeordnet sein kann.

Fig. 4 zeigt eine dritte Ausführungsform der Abdeckeinheit 100. Soweit keine Unterschiede beschrieben werden, ist die dritte Ausführungsform der Abdeckeinheit 100 ausgebildet, wie es für die zweite Ausführungsform der Abdeckeinheit 100 beschrieben wird. Die dritte Ausführungsform der Abdeckeinheit 100 umfasst neben dem ersten und zweiten Absorptionsglas 110, 120 ein drittes Absorptionsglas 130. Das dritte Absorptionsglas 130 ist ebenfalls als IR-Absorptionsglas ausgebildet und auf der dem Bildsensor 20 zugewandten Rückseite 122 des zweiten Absorptionsglases 120 angeordnet. Das zweite Absorptionsglas 120 und das dritte Absorptionsglas 130 liegen aneinander an. Zwischen dem zweiten Absorptionsglas 120 und dem dritten Absorptionsglas 130 ist eine IR-Sperrschicht 150 angeordnet.

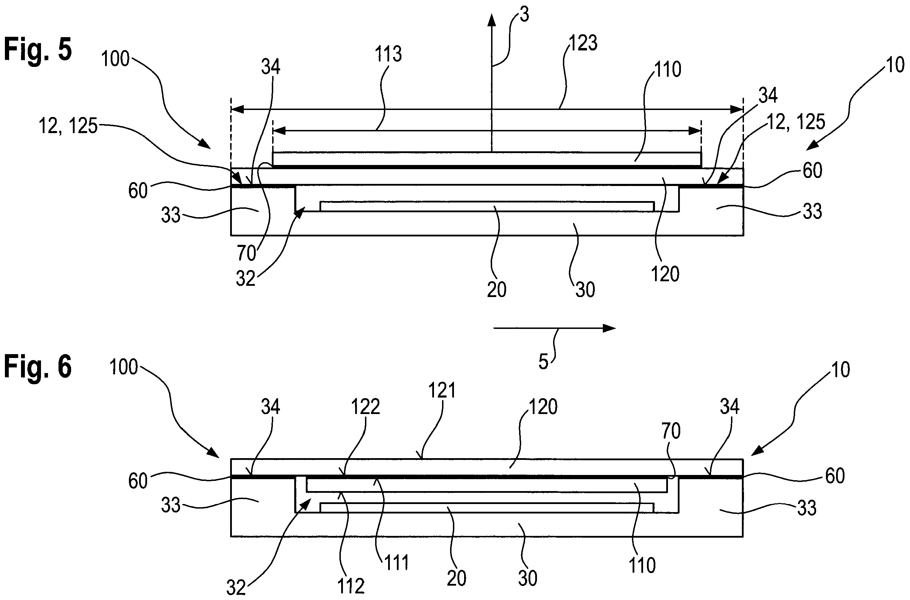

Fig. 5 zeigt die Sensoreinheit 10 mit einer vierten Ausführungsform der Abdeckeinheit 100. Soweit keine Unterschiede beschrieben werden, ist die vierte Ausführungsform der Abdeckeinheit 100 ausgebildet, wie es für die zweite Ausführungsform beschrieben wird. Bei der vierten Ausführungsform ist in der transversalen Richtung 5 eine Ausdehnung 113 des ersten Absorptionsglases 110 kleiner als eine Ausdehnung 123 des zweiten Absorptionsglases 120. Dadurch weist das zweite Absorptionsglas 120 in der transversalen Richtung 5 beidseits in einem Randbereich 12 der Abdeckeinheit 100 einen freiliegenden Bereich 125 auf, der in longitudinaler Richtung 3 nicht durch das erste Absorptionsglas 110 überdeckt wird und in dem das zweite Absorptionsglas 120 unter dem ersten Absorptionsglas 110 freiliegt.

Das zweite Absorptionsglas 120 liegt auf seiner Rückseite 122 auf einer Auflagefläche 34 eines Rahmens 33 eines Gehäuses 30 der Sensoreinheit 10 auf. Der Rahmen 33 begrenzt umlaufend eine Kavität 32 des Gehäuses 30, in der der optoelektronische Bildsensor 20 angeordnet ist. Durch das zweite Absorptionsglas 120 wird die Kavität 32 in longitudinaler Richtung 3 verschlossen. Das zweite Absorptionsglas 120 ist in dem freiliegenden Bereich 125 mit dem Rahmen 33 mittels einer einen UV-lichthärtenden Klebstoff umfassenden Klebeverbindung 60 verbunden. Die Klebeverbindung 60 wird in dem freiliegenden Bereich 125 nicht durch das als UV-Absorptionsglas ausgebildete erste Absorptionsglas 110 überdeckt, so dass UV-Licht, welches zur Aushärtung des Klebstoffes von vorne auf die Abdeckeinheit 100 eingestrahlt wird, an dem ersten Absorptionsglas 110 vorbei und durch das zweite Absorptionsglas 120 hindurch auf die Klebeverbindung 60 einfallen kann.

Fig. 6 zeigt die Sensoreinheit 10 mit einer fünften Ausführungsform der Abdeckeinheit 100. Soweit keine Unterschiede beschrieben werden, ist die fünfte Ausführungsform der Abdeckeinheit 100 ausgebildet, wie es für die vierte Ausführungsform beschrieben wird. Bei der fünften Ausführungsform ist das erste Absorptionsglas 110 auf der Rückseite 122 des zweiten Absorptionsglases 120 und in der Kavität 32 angeordnet. Bei dieser Ausführungsform ist die Vorderseite 111 des ersten Absorptionsglases 110 mit der Rückseite 122 des zweiten Absorptionsglases 120 mittels der Verbindungsschicht 70 verbunden. Bei der fünften Ausführungsform der Abdeckeinheit 100 kann das UV-Licht zur Aushärtung des Klebstoffes der zwischen dem zweiten Absorptionsglas 120 und dem Rahmen 33 des Gehäuses 30 angeordneten Klebeverbindung 60 direkt durch das zweite Absorptionsglas 120 eingestrahlt werden.

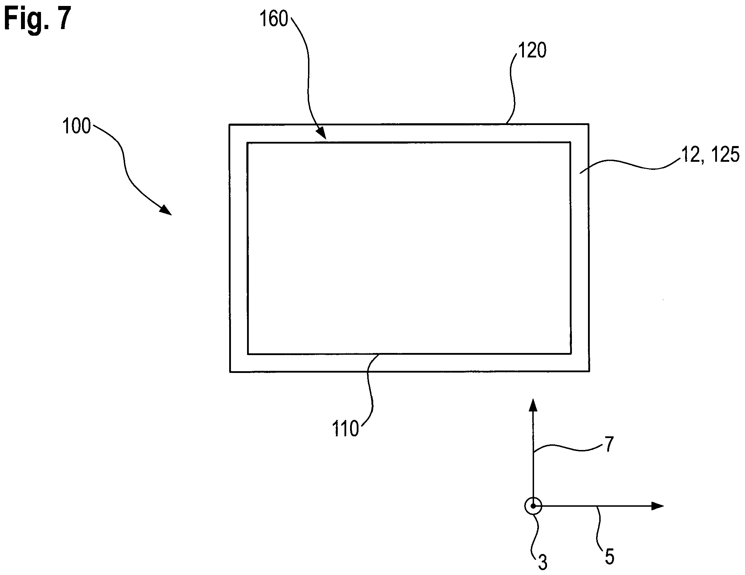

Fig. 7 zeigt eine Aufsicht auf eine Vorderseite der in Fig. 5 dargestellten vierten Ausführungsform der Abdeckeinheit 110. Das erste Absorptionsglas 110 weist sowohl in der transversalen Richtung 5, als auch in einer zu der transversalen Richtung 5 und der longitudinalen Richtung 3 senkrecht orientierten weiteren transversalen Richtung 7 jeweils eine Ausdehnung auf, welche kleiner ist als eine entsprechende Ausdehnung des zweiten Absorptionsglases 120. Dadurch wird das zweite Absorptionsglas 120 in einem umlaufenden Randbereich 12 nicht durch das erste Absorptionsglas 110 überdeckt, so dass der in dem Randbereich 12 freiliegende Bereich 125 des zweiten Absorptionsglases 120 ebenfalls umlaufend ausgebildet ist.

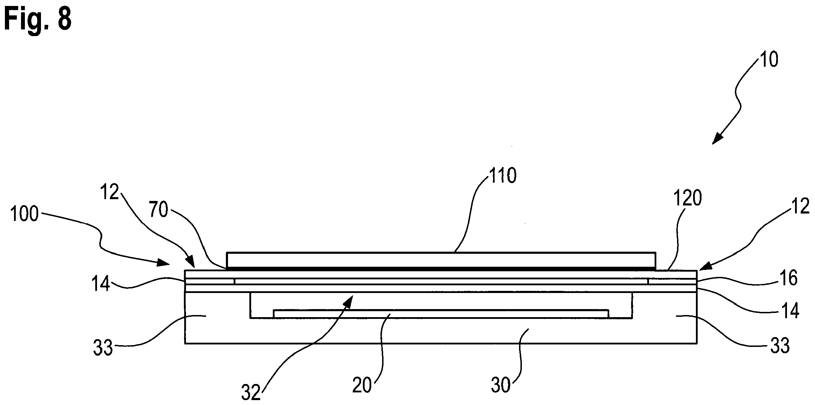

Fig. 8 zeigt die Sensoreinheit 10 mit einer sechsten Ausführungsform der Abdeckeinheit 100. Soweit keine Unterschiede beschrieben werden, ist die sechste Ausführungsform der Abdeckeinheit 100 ausgebildet, wie es für die vierte Ausführungsform beschrieben wird. Bei der sechsten Ausführungsform liegt das zweite Absorptionsglas 120 nicht direkt auf dem Rahmen 33 des Gehäuses 30 auf. Stattdessen ist vor dem Gehäuse 30 ein Abdeckglas 14 angeordnet, welches die Kavität 32 in longitudinaler Richtung verschließt. Das Abdeckglas 14 kann als ein Klarglas ausgebildet sein, welches einfallende elektromagnetische Strahlung im sichtbaren Spektralbereich im Wesentlichen ungehindert transmittiert. Die Abdeckeinheit 100 ist mit dem Abdeckglas 14 verbunden, wobei zwischen der Abdeckeinheit 100 und dem Abdeckglas 14 ein Abstandshalter 16 angeordnet ist. Dadurch weisen die Abdeckeinheit 100 und das Abdeckglas 14 in longitudinaler Richtung 3 einen Abstand voneinander auf. Der Abstandhalter 16 ist um die Abdeckeinheit 100 in dem Randbereich 12 umlaufend ausgebildet.

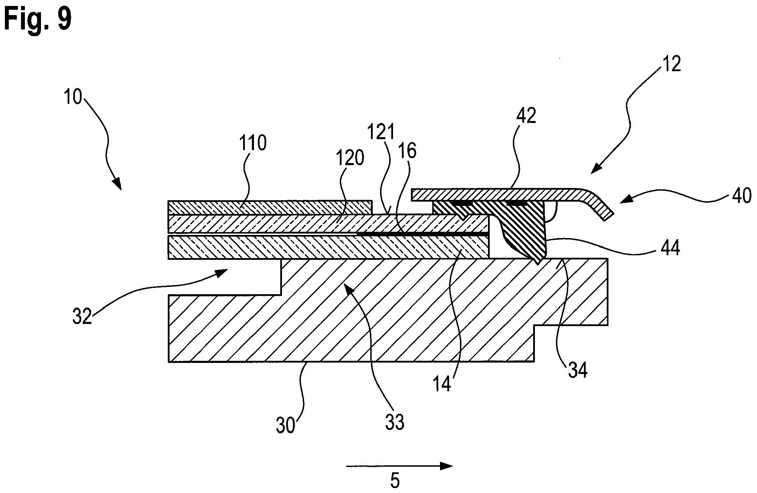

Fig. 9 zeigt eine Detailansicht der Sensoreinheit 100 mit der sechsten Ausführungsform der Abdeckeinheit 100. Die Abdeckeinheit 100 ist mittels eines in Fig. 8 nicht dargestellten Befestigungselements 40 an dem Gehäuse 30 der Sensoreinheit 10 befestigt. Das Befestigungselement 40 liegt in dem nicht durch das erste Absorptionsglas 110 überdeckten Randbereich 12 auf der Vorderseite 121 des zweiten Absorptionsglases 120 auf und klemmt das zweite Absorptionsglas 120 auf die Auflagefläche 34 des Rahmens 33. Das Befestigungselement 40 umfasst ein Klemmelement 42 und ein zwischen dem Klemmelement 42 und dem zweiten Absorptionsglas 120 angeordnetes Dichtungselement 44. Das Klemmelement 42 ist um die Abdeckeinheit 100 in dem Randbereich 12 umlaufend angeordnet und als ein Halteblech ausgebildet. Das Dichtungselement 44 ist ebenfalls in dem Randbereich 12 umlaufend um die Abdeckeinheit 100 angeordnet und umfasst ein elastisches Material. Das Dichtungselement 44 liegt in transversaler Richtung 5 neben der Abdeckeinheit 100 auch auf dem Rahmen 33 des Gehäuses 30 auf.

Bei alternativen Ausführungsformen der in Fig. 8 dargestellten Sensoreinheit 10 kann der Abstandhalter 16 mit der Abdeckeinheit 100 und dem Abdeckglas 14 auch jeweils mittels einer Klebeverbindung, etwa mittels einer einen UV-lichthärtenden Kunststoff umfassenden Klebeverbindung, verbunden sein. Bei diesen Ausführungsformen kann das Befestigungselement 40 entfallen.

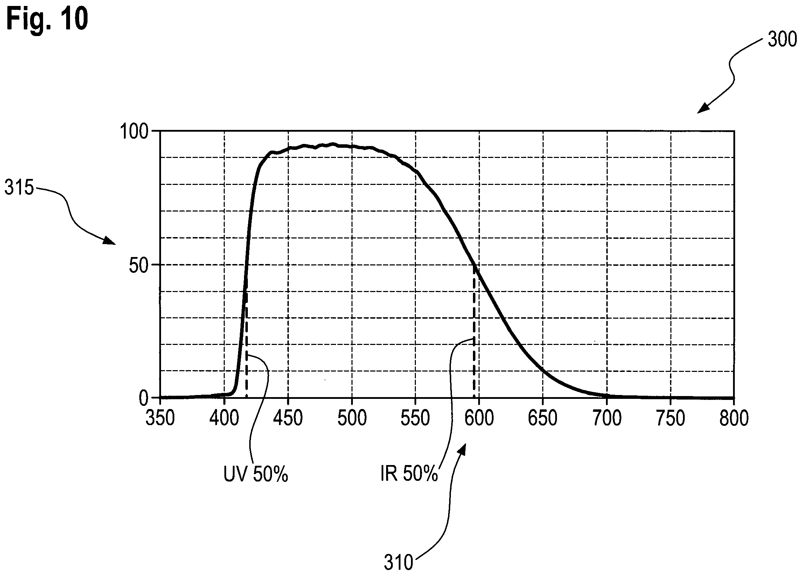

Fig. 10 zeigt eine Transmissionskurve 300 der zweiten und vierten bis sechsten Ausführungsform der Abdeckeinheit 100, wobei die Transmission 315 (in %) der Abdeckeinheit 100 gegen die Wellenlänge 310 (in nm) der einfallenden elektromagnetischen Strahlung aufgetragen ist. Wie Fig. 10 zu entnehmen ist, weist die Transmissionskurve 300 im violetten Spektralbereich eine Grenzwellenlänge UV50% bei 417nm und im infraroten Spektralbereich eine Grenzwellenlänge IR50% bei 596nm auf. Die Transmissionskurve 300 wurde mit einer Ausführungsform der Abdeckeinheit 100 aufgenommen, welche als erstes Absorptionsglas 110 ein Glas UV8010HT der Firma Corning SAS mit einer longitudinalen Dicke von 0,3mm und als zweites Absorptionsglas ein Glas CXA700 der Firma Hoya Corporation mit einer longitudinalen Dicke von 0,565mm umfasst.

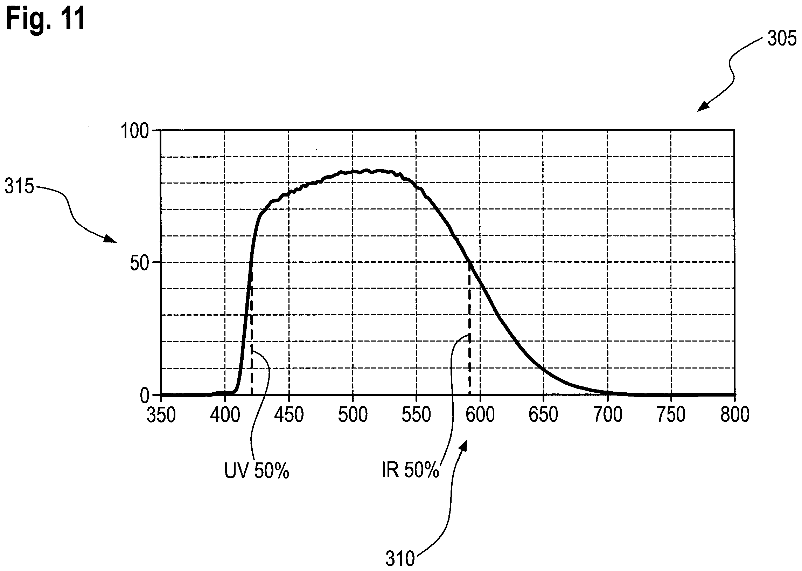

Fig. 11 zeigt eine alternative Transmissionskurve 305 der zweiten und vierten bis sechsten Ausführungsform der Abdeckeinheit 100. Wie Fig. 11 zu entnehmen ist, weist die Transmissionskurve 305 im violetten Spektralbereich eine Grenzwellenlänge UV50% bei 419nm und im infraroten Spektralbereich eine Grenzwellenlänge IR50% bei 591nm auf. Die Transmissionskurve 305 wurde mit einer Ausführungsform der Abdeckeinheit 100 aufgenommen, welche als erstes Absorptionsglas 110 ein Glas UV8010HT der Firma Corning SAS mit einer longitudinalen Dicke von 0,3mm und als zweites Absorptionsglas ein Glas IR 584-18α der Firma MATSUNAMI GLASS IND., LTD mit einer longitudinalen Dicke von 0,762mm umfasst.

### Bezugszeichenliste

- 1: Bildaufnahmegerät
- 2: optische Achse
- 3: longitudinale Richtung
- 5: transversale Richtung
- 7: weitere transversale Richtung
- 8: Schnittweite
- 9: Objekt
- 10: Sensoreinheit
- 12: Randbereich
- 14: Abdeckglas
- 16: Abstandshalter
- 20: Bildsensor
- 22: Oberfläche
- 30: Gehäuse
- 32: Kavität
- 33: Rahmen
- 34: Auflagefläche
- 40: Befestigungselement
- 42: Klemmelement
- 44: Dichtungselement
- 60: Klebeverbindung
- 70: Verbindungsschicht
- 82: optisches Element
- 90: Abdeckeinheit
- 92: Sperrschicht
- 94: Absorptionsglas
- 100: Abdeckeinheit
- 110: erstes Absorptionsglas
- 111: Vorderseite
- 112: Rückseite
- 113: Ausdehnung
- 120: zweites Absorptionsglas
- 121: Vorderseite
- 122: Rückseite
- 123: Ausdehnung
- 125: freiliegender Bereich
- 130: drittes Absorptionsglas
- 150: IR-Sperrschicht
- 200: elektromagnetische Strahlung
- 202: zweiter Einfallswinkel nach Reflektion
- 203: erster Einfallswinkel
- 300: Transmissionskurve
- 305: alternative Transmissionskurve
- 310: Wellenlänge
- 315: Transmission

## Patentansprüche

1. Sensoreinheit (10) für ein Bildaufnahmegerät (1) mit einem optoelektronischen Bildsensor (20) und einer vor dem optoelektronischen Bildsensor (20) angeordneten Abdeckeinheit (100), wobei
die Abdeckeinheit (100) ein erstes Absorptionsglas (110) und ein zweites Absorptionsglas (120) umfasst und
das erste Absorptionsglas (110) als ein UV-Absorptionsglas und das zweite Absorptionsglas (120) als ein IR-Absorptionsglas ausgebildet ist.

2. Sensoreinheit (10) nach Anspruch 1, wobei das erste Absorptionsglas (110) an einer dem Bildsensor (20) abgewandten Vorderseite (121) des zweiten Absorptionsglases (120) angeordnet ist.

3. Sensoreinheit (10) nach Anspruch 1, wobei das erste Absorptionsglas (110) an einer dem Bildsensor (20) zugewandten Rückseite (122) des zweiten Absorptionsglases (120) angeordnet ist.

4. Sensoreinheit (10) nach einem der vorhergehenden Ansprüche, wobei die Abdeckeinheit (100) eine den Bildsensor (20) enthaltende Kavität (32) der Sensoreinheit (10) überdeckt.

5. Sensoreinheit (10) nach einem der vorhergehenden Ansprüche, wobei das erste Absorptionsglas (110) und/oder das zweite Absorptionsglas (120) als plattenförmiges Element ausgebildet ist, welches in einer senkrecht zu einer Oberfläche (22) des Bildsensors (20) ausgerichteten Dickenrichtung (3) eine geringere Ausdehnung aufweist als in parallel zu der Oberfläche (22) des Bildsensors (20) ausgerichteten transversalen Richtungen (5, 7).

6. Sensoreinheit (10) nach einem der vorhergehenden Ansprüche, wobei das erste Absorptionsglas (110) und das zweite Absorptionsglas (120) aneinander liegend angeordnet und vorzugsweise flächig miteinander verbunden, beispielsweise verkittet, verklebt oder angesprengt, sind.

7. Sensoreinheit (10) nach einem der vorhergehenden Ansprüche, wobei
sich ein erster Brechungsindex des ersten Absorptionsglases (110) um höchstens 10%, beispielsweise um höchstens 3% oder höchstens 1%, von einem zweiten Brechungsindex des zweiten Absorptionsglases (120) unterscheidet, und
wobei bevorzugt sich ein dritter Brechungsindex einer zwischen dem ersten Absorptionsglas (110) und dem zweiten Absorptionsglas (120) angeordneten Verbindungsschicht (70) von dem ersten Brechungsindex und/oder dem zweiten Brechungsindex um höchstens 10%, beispielsweise um höchstens 3% oder höchstens 1%, unterscheidet.

8. Sensoreinheit (10) nach einem der vorhergehenden Ansprüche, wobei ein Kleineres der beiden Absorptionsgläser (110, 120) in einer parallel zu einer Oberfläche (22) des Bildsensors (20) orientierten lateralen Richtung (5, 7) eine geringere Ausdehnung aufweist als ein Größeres der beiden Absorptionsgläser (120, 110).

9. Sensoreinheit (10) nach Anspruch 8, wobei
die Abdeckeinheit (100) auf einer Auflagefläche (34) eines den optoelektronischen Bildsensor (20) umgebenden Rahmens (33) der Sensoreinheit (10) aufliegt, und
die Auflagefläche (34) in der lateralen Richtung (5, 7) zumindest teilweise nicht durch das kleinere Absorptionsglas (110, 120) überdeckt wird.

10. Sensoreinheit (10) nach Anspruch 9, wobei
das kleinere Absorptionsglas durch das erste Absorptionsglas (110) und das größere Absorptionsglas durch das zweite Absorptionsglas (120) gebildet wird, und
zwischen dem zweiten Absorptionsglas (120) und dem Bildsensor (20) in einem in der lateralen Richtung (5, 7) nicht durch das erste Absorptionsglas (110) überdeckten Randbereich (12) der Sensoreinheit (10) eine einen UV-lichthärtenden Klebstoff umfassende Klebeverbindung (60) angeordnet ist, und
beispielsweise die Klebeverbindung (60) das zweite Absorptionsglas (120) mit einem den optoelektronischen Bildsensor (20) umgebenden Rahmen (33) der Sensoreinheit (10) verbindet.

11. Sensoreinheit (10) nach einem der Ansprüche 8 bis 10, wobei
die Sensoreinheit (10) ein Befestigungselement (40) umfasst, mit welchem die Abdeckeinheit (100) an dem optoelektronischen Bildsensor (20) befestigt ist, und
das Befestigungselement (40) an einer dem kleineren Absorptionsglas (110, 120) zugewandten Befestigungsseite (121) des größeren Absorptionsglases (110, 120) und in der lateralen Richtung (5, 7) neben dem kleineren Absorptionsglas (110, 120) angeordnet ist.

12. Sensoreinheit (10) nach einem der Ansprüche 8 bis 11, wobei das größere Absorptionsglas (110, 120) auf seiner dem kleineren Absorptionsglas (110, 120) zugewandten Seite (121) eine Schutzbeschichtung aufweist, welche zumindest einen in der lateralen Richtung (5, 7) nicht durch das kleinere Absorptionsglas (110, 120) überdeckten freiliegenden Bereich (125) des größeren Absorptionsglases (110, 120) bedeckt, und wobei bevorzugt die Schutzbeschichtung vollflächig auf der dem kleineren Absorptionsglas (110, 120) zugewandten Seite (121) des größeren Absorptionsglases (110, 120) angeordnet ist.

13. Sensoreinheit (10) nach einem der vorhergehenden Ansprüche, wobei die Abdeckeinheit (100) eine IR-Sperrschicht (150) umfasst.

14. Sensoreinheit (10) nach Anspruch 13, wobei
die Abdeckeinheit (100) ein drittes Absorptionsglas (130) umfasst, welches als ein IR-Absorptionsglas ausgebildet ist, und dass die IR-Sperrschicht (150) zwischen dem zweiten und dem dritten Absorptionsglas (120, 130) angeordnet ist, und
wobei bevorzugt das dritte Absorptionsglas (130) auf einer dem ersten Absorptionsglas (110) abgewandten Seite (122) des zweiten Absorptionsglases (120) angeordnet ist.

15. Bildaufnahmegerät (1) mit einer Sensoreinheit (10) gemäß einem der vorhergehenden Ansprüche.

## Claims

1. A sensor unit (10) for an image recording device (1), said sensor unit (10) comprising an optoelectronic image sensor (20) and a cover unit (100) arranged in front of the optoelectronic image sensor (20),
wherein the cover unit (100) comprises a first absorption glass (110) and a second absorption glass (120), and
wherein the first absorption glass (110) is configured as a UV absorption glass and the second absorption glass (120) is configured as an IR absorption glass.

2. A sensor unit (10) in accordance with claim 1,
wherein the first absorption glass (110) is arranged at a front side (121) of the second absorption glass (120) remote from the image sensor (20).

3. A sensor unit (10) in accordance with claim 1,
wherein the first absorption glass (110) is arranged at a rear side (122) of the second absorption glass (120) facing the image sensor (20).

4. A sensor unit (10) in accordance with any one of the preceding claims, wherein the cover unit (100) covers a cavity (32) of the sensor unit (10) in which the image sensor (20) is arranged.

5. A sensor unit (10) in accordance with any one of the preceding claims, wherein the first absorption glass (110) and/or the second absorption glass (120) is/are configured as a plate-shaped element which has a smaller extent in a thickness direction (3) oriented perpendicular to a surface (22) of the image sensor (20) than in transverse directions (5, 7) aligned in parallel with the surface (22) of the image sensor (20).

6. A sensor unit (10) in accordance with any one of the preceding claims, wherein the first absorption glass (110) and the second absorption glass (120) are arranged contacting one another and are preferably areally connected to one another, for example, cemented, adhesively bonded, or bonded by optical contacting.

7. A sensor unit (10) in accordance with any one of the preceding claims,
wherein a first refractive index of the first absorption glass (110) differs from a second refractive index of the second absorption glass (120) by at most 10%, for example, by at most 3% or at most 1%, and
wherein a third refractive index of a connection layer (70) arranged between the first absorption glass (110) and the second absorption glass (120) preferably differs from the first refractive index and/or the second refractive index by at most 10%, for example, by at most 3% or at most 1%.

8. A sensor unit (10) in accordance with any one of the preceding claims, wherein a smaller one of the two absorption glasses (110, 120) has a smaller extent in a lateral direction (5, 7) oriented in parallel with a surface (22) of the image sensor (20) than a larger one of the two absorption glasses (120, 110).

9. A sensor unit in accordance with claim 8,
wherein the cover unit (100) is disposed on a support surface (34) of a frame (33) of the sensor unit (10) surrounding the optoelectronic image sensor (20), and
wherein the support surface (34) is at least partly not covered by the smaller absorption glass (110, 120) in the lateral direction (5, 7).

10. A sensor unit in accordance with claim 9,
wherein the smaller absorption glass is formed by the first absorption glass (110) and the larger absorption glass is formed by the second absorption glass (120), and
wherein an adhesive connection (60) comprising a UV light-curing adhesive is arranged between the second absorption glass (120) and the image sensor (20) in a marginal region (12) of the sensor unit (10) that is not covered by the first absorption glass (110) in the lateral direction (5, 7), and wherein the adhesive connection (60), for example, connects the second absorption glass (120) to a frame (33) of the sensor unit (10) surrounding the optoelectronic image sensor (20).

11. A sensor unit (10) in accordance with any one of the claims 8 to 10,
wherein the sensor unit (10) comprises a fastening element (40) by which the cover unit (100) is fastened to the optoelectronic image sensor (20), and
wherein the fastening element (40) is arranged at a fastening side (121) of the larger absorption glass (110, 120) facing the smaller absorption glass (110, 120) and is arranged next to the smaller absorption glass (110, 120) in the lateral direction (5, 7).

12. A sensor unit (10) in accordance with any one of the claims 8 to 11,
wherein the larger absorption glass (110, 120) has, at its side (121) facing the smaller absorption glass (110, 120), a protective coating which covers at least one exposed region (125) of the larger absorption glass (110, 120) that is not covered by the smaller absorption glass (110, 120) in the lateral direction (5, 7), and
wherein the protective coating is preferably arranged over the full area at the side (121) of the larger absorption glass (110, 120) facing the smaller absorption glass (110, 120).

13. A sensor unit (10) in accordance with any one of the preceding claims, wherein the cover unit (100) comprises an IR barrier layer (150).

14. A sensor unit (10) in accordance with claim 13,
wherein the cover unit (100) comprises a third absorption glass (130) which is configured as an IR absorption glass, and
wherein the IR barrier layer (150) is arranged between the second and third absorption glass (12, 130), and
wherein the third absorption glass (130) is preferably arranged at a side (122) of the second absorption glass (120) remote from the first absorption glass (110).

15. An image recording device (1) comprising a sensor unit (10) in accordance with any one of the preceding claims.

## Revendications

1. Unité de détection (10) pour un appareil de prise de vues (1), comprenant
un capteur d'images optoélectronique (20) et une unité de recouvrement (100) disposée devant le capteur d'images optoélectronique (20),
dans laquelle
l'unité de recouvrement (100) comprend un premier verre absorbant (110) et un deuxième verre absorbant (120), et
le premier verre absorbant (110) est réalisé sous forme de verre absorbant les UV et le deuxième verre absorbant (120) est réalisé sous forme de verre absorbant les IR.

2. Unité de détection (10) selon la revendication 1,
dans laquelle
le premier verre absorbant (110) est disposé sur une face avant (121) du deuxième verre absorbant (120) détournée du capteur d'images (20).

3. Unité de détection (10) selon la revendication 1,
dans laquelle
le premier verre absorbant (110) est disposé sur une face arrière (122) du deuxième verre absorbant (120) tournée vers le capteur d'images (20).

4. Unité de détection (10) selon l'une des revendications précédentes,
dans laquelle
l'unité de recouvrement (100) recouvre une cavité (32) de l'unité de détection (10) contenant le capteur d'images (20).

5. Unité de détection (10) selon l'une des revendications précédentes,
dans laquelle
le premier verre absorbant (110) et/ou le deuxième verre absorbant (120) est réalisé sous forme d'élément en forme de plaque qui présente une extension plus faible dans une direction d'épaisseur (3) orientée perpendiculairement à une surface (22) du capteur d'images (20) que dans des directions transversales (5, 7) orientées parallèlement à la surface (22) du capteur d'images (20).

6. Unité de détection (10) selon l'une des revendications précédentes,
dans laquelle
le premier verre absorbant (110) et le deuxième verre absorbant (120) sont disposés en appui l'un contre l'autre et sont de préférence reliés à plat l'un à l'autre, par exemple par masticage, collage ou accolage.

7. Unité de détection (10) selon l'une des revendications précédentes,
dans laquelle
un premier indice de réfraction du premier verre absorbant (110) diffère d'un deuxième indice de réfraction du deuxième verre absorbant (120) de 10 % au maximum, par exemple de 3 % au maximum ou de 1 % au maximum, et de préférence, un troisième indice de réfraction d'une couche de liaison (70) disposée entre le premier verre absorbant (110) et le deuxième verre absorbant (120) diffère du premier indice de réfraction et/ou du deuxième indice de réfraction de 10 % au maximum, par exemple de 3 % au maximum ou de 1 % au maximum.

8. Unité de détection (10) selon l'une des revendications précédentes,
dans laquelle
un plus petit des deux verres absorbants (110, 120) présente une extension plus faible dans une direction latérale (5, 7) orientée parallèlement à une surface (22) du capteur d'images (20) qu'un plus grand des deux verres absorbants (120, 110).

9. Unité de détection (10) selon la revendication 8,
dans laquelle
l'unité de recouvrement (100) repose sur une surface d'appui (34) d'un cadre (33) de l'unité de détection (10), lequel entoure le capteur d'images optoélectronique (20), et
la surface d'appui (34) n'est pas recouverte au moins partiellement par le petit verre absorbant (110, 120) dans la direction latérale (5, 7).

10. Unité de détection (10) selon la revendication 9,
dans laquelle
le petit verre absorbant est formé par le premier verre absorbant (110) et le grand verre absorbant est formé par le deuxième verre absorbant (120), et une liaison collée (60) comprenant une colle durcissant à la lumière UV est disposée entre le deuxième verre absorbant (120) et le capteur d'images (20), dans une zone de bordure (12) de l'unité de détection (10) non recouverte par le premier verre absorbant (110) dans la direction latérale (5, 7), et
par exemple, la liaison collée (60) relie le deuxième verre absorbant (120) à un cadre (33) de l'unité de détection (10), lequel entoure le capteur d'images optoélectronique (20).

11. Unité de détection (10) selon l'une des revendications 8 à 10,
dans laquelle
l'unité de détection (10) comprend un élément de fixation (40) par lequel l'unité de recouvrement (100) est fixée au capteur d'images optoélectronique (20), et
l'élément de fixation (40) est disposé sur une face de fixation (121) du grand verre absorbant (110, 120), tournée vers le petit verre absorbant (110, 120), et à côté du petit verre absorbant (110, 120) dans la direction latérale (5, 7).

12. Unité de détection (10) selon l'une des revendications 8 à 11,
dans laquelle
le grand verre absorbant (110, 120) présente, sur sa face (121) tournée vers le petit verre absorbant (110, 120), un revêtement de protection qui recouvre au moins une zone découverte (125) du grand verre absorbant (110, 120), qui n'est pas recouverte par le petit verre absorbant (110, 120) dans la direction latérale (5, 7), et
de préférence, le revêtement de protection est disposé avec toute sa surface sur la face (121) du grand verre absorbant (110, 120) tournée vers le petit verre absorbant (110, 120).

13. Unité de détection (10) selon l'une des revendications précédentes,
dans laquelle
l'unité de recouvrement (100) comprend une couche de blocage des IR (150).

14. Unité de détection (10) selon la revendication 13,
dans laquelle
l'unité de recouvrement (100) comprend un troisième verre absorbant (130) qui est réalisé sous forme de verre absorbant les IR, et
la couche de blocage des IR (150) est disposée entre le deuxième et le troisième verre absorbant (120, 130), et
de préférence, le troisième verre absorbant (130) est disposé sur une face (122) du deuxième verre absorbant (120) détournée du premier verre absorbant (110).

15. Appareil de prise de vues (1) comprenant une unité de détection (10) selon l'une des revendications précédentes.
